# EUROPEAN PATENT SPECIFICATION

(11) **EP 3 162 715 B1**
(45) Date of publication and mention of the grant of the patent: **11.09.2019**
(21) Application number: 16194201.6
(22) Date of filing: 17.10.2016
(51) Int. Cl.: B64G 1/22, B64G 1/44, H01L 31/042, H02S 20/00, H02S 30/20, B64G 1/50, B64G 1/66

(54) **METHOD FOR RELEASING A DEPLOYABLE BOOM**
VERFAHREN ZUR FREISETZUNG EINES AUSKLAPPBAREN AUSLEGERS
PROCÉDÉ PERMETTANT DE LIBÉRER UNE FLÈCHE DÉPLOYABLE

(30) Priority: 23.10.2015 US 201514921238; 20.01.2016 US 201615001962
(43) Date of publication of application: 03.05.2017
(73) Proprietor: SolAero Technologies Corp., Albuquerque, NM 87123 (US)
(72) Inventor: STEELE, Kenneth Loyd, Carlsbad, CA 92011 (US); STERN, Theodore Garry, El Cajon, CA 92020 (US)
(74) Representative: Balder IP Law, S.L.

(56) References cited:
- US-A- 6 137 454
- US-A1- 2011 210 209
- US-B1- 9 004 410
- US-B1- 9 156 568
- COSTANTINE J ET AL: "CubeSat Deployable Antenna Using Bistable Composite Tape-Springs", IEEE ANTENNAS AND WIRELESS PROPAGATION LETTERS, IEEE, PISCATAWAY, NJ, US, vol. 11, 1 January 2012 (2012-01-01), pages 285-288, XP011489159, ISSN: 1536-1225, DOI: 10.1109/LAWP.2012.2189544
- J C H Yee ET AL: "Carbon Fibre Reinforced Plastic Tape Springs", Proceedings of the 45th AIAA/ASME/ASCE/AHS/ASC Structures, Structural Dynamics and Materials Conference, AIAA Paper 2004-1819, 22 April 2004 (2004-04-22), XP055356036, Retrieved from the Internet: URL:http://www-civ.eng.cam.ac.uk/dsl/publi cations/CFRP_tape_springs_Paper.pdf [retrieved on 2017-03-17]

## Description

### BACKGROUND OF THE DISCLOSURE

### 1. Field of the Disclosure

The present disclosure relates to deployable booms associated with vehicles or permanent structures, the booms being structured components, or assemblies including, in some embodiments, transducers for collecting or emitting electromagnetic energy.

### 2. Description of the Related Art

Solar photovoltaic arrays are commonly used to power spacecraft. Spacecraft needing high power generation typically use solar array wings that fold or roll-up for launch (because of the constraints of available volume within the launch vehicle), then unfold or unroll in space to present a large solar collection area as-needed to intercept sufficient sunlight to generate the required power. A common approach is to mount the solar cells onto rigid panels, accordion-fold the panels for stowage, and subsequently deploy them in space using hinges between the panels and a supplied deployment force. The common approach has limitations in how compactly the arrays can be packaged, because of the inherent volume and inflexibility of the rigid panels that are used as mounting substrates for the photovoltaic assemblies.

To overcome the packaging limitations of rigid panels, reduce mass, and reduce packaged volume, a Solar Cell Blanket is often used. A Solar Cell Blanket may comprise a thin, flexible assembly of solar cells, coverglass, interconnects, terminal strips, and insulating film that may be unsupported, instead of mounted on thick rigid panel structures. These thin flexible membranes are normally supplemented with a separate deployable super-structure or scaffold that provides the means to deploy the folded or rolled-up solar array into its final deployed configuration and to provide the structural rigidity to hold the deployed array, since the flexible membrane is not a rigid structure. The deployed super-structure is typically attached to an orientation device on a spacecraft so as to allow the solar array to be pointed towards the sun. The super-structure also allows the array to withstand the structural loads that may be placed on the deployed array during spacecraft operations, including loads from accelerations that occur during the spacecraft's operating life, including orbital and orientation maneuvers.

Prior methods to provide the super-structure for a flexible membrane deployable solar array typically use umbrella-like, or oriental-fan-like structures to deploy and maintain the structure of a circular solar array, or one or two deployable booms to deploy a rolled or folded rectangular array. The solar arrays found on the Space Station and on the Hubble telescope are examples of rectangular arrays that use a single deployable boom or a pair of deployable booms, respectively, to deploy a flexible solar array and provide deployed structural rigidity. Such flexible membrane solar arrays with discrete and separate super-structures are limited in the shielding provided to the backside of the solar array after deployment, and by the complexity of deploying such an array with tensioning interfaces between the deployable boom and the nonstructural solar array blanket.
US-9004410-B1 discloses an assembly for collecting electromagnetic energy comprising a boom having a deployable length and width, and two layers, one of them comprising a flexible substrate pre-formed in a lenticular shape and adapted to elastically deform. The assembly comprises a rotational drive mechanism that assists in changing the configuration of the assembly.

CubeSats are a type of miniaturized satellites. Although there is a desire to provide power for CubeSats from solar panels, the known methods of providing solar arrays described above are difficult or impossible to apply to CubeSats because of the small size of the CubeSat and the limited space available on the CubeSat. Accordingly, there is a need for an improved system that overcomes these and other limitations.

### SUMMARY

Briefly, and in general terms, the present disclosure describes a method of deploying an extensible boom from a housing comprising:
providing a support including an array of transducer devices;
mounting the support on a first flexible, elongated, rectangular sheet in a housing, the sheet composed of a composite laminate having a predetermined pattern of graphite fiber plies which impart a predefined tension in the planar surface of the sheet so that it curls into a curvilinear sheet having a uniform radius of curvature along its major axis;
supporting the sheet on a spool in the housing under compression in a stowed configuration; and
releasing the spool so that the sheet unwinds automatically and is deployed from the housing in a linear direction.

In some embodiments, the array of transducer devices is selected from groups of (i) an array of photovoltaic devices; (ii) an array of semiconductor sensors; (iii) an antenna array; and/or (iv) thermal transfer elements.

In some embodiments, the transducers are mounted on a polyimide carrier and the polyimide carrier is bonded to the composite laminate.

In some embodiments, the flexible sheet has a thickness of between 0.1 mm and 0.5 mm, a width of less than 10 cm, and a length of between 10 and 200 cm after full deployment.

In some embodiments, the array of transducer devices include a first transducer module having a first side dimension, and a second transducer module having a second side dimension different from the first side dimension.

In some embodiments, each transducer module includes a plurality of discrete photovoltaic solar cells connected in an electrical serial or parallel configuration.

In some embodiments, the array of photovoltaic solar cell devices includes an array of coverglass-interconnected-solar cells (CICs) mounted on the polyimide carrier by a pressure sensitive adhesive.

In some embodiments, the pattern of graphite fiber plies is pre-impregnated with resin and consist of at least intermediate modulus graphite fiber reinforced plies to impart substantially uniform strength, stiffness, and flexibility.

In some embodiments, the graphite fiber plies gives the sheet a strength of up to 2.0 g and a stiffness resulting in a natural frequency greater than 0.01 Hz.

In some embodiments, the sheet is circumferentially wound to form a spool configuration in a stowed configuration, and forms into a cylindrical portion sheet having a uniform cross-sectional curvature as it unwinds from the spool configuration upon deployment to the deployed configuration.

In some embodiments, the sheet is stored within a one unit CubeSat housing for a space vehicle in its stowed configuration.

In some embodiments, the method further comprises:
providing a second flexible, elongated, substantially rectangular sheet for supporting a plurality of transducer assemblies;
supporting the second rectangular sheet in a spooled configuration under compression on a mandrel in a stationary position in a stowed configuration; and
releasing the second sheet from the spooled configuration by releasing the mandrel to allow it to rotate during a deployment operation so that the sheet automatically deploys from the mandrel and curls into a curvilinear sheet having a uniform radius of curvature along its major axis and extending substantially linearly away from the housing.

In some embodiments, the first and second sheets are substantially simultaneously deployed so that the first sheet is deployed in a first direction from the housing and the second sheet is deployed in the same plane as the first sheet but in an opposite direction from the housing.

In some embodiments, the housing is disposed in a spacecraft, and the spacecraft is composed of CubeSat modules, wherein the first and second rectangular sheets are stowed within a one unit CubeSat housing.

In some embodiments, the housing is disposed in a vehicle.

In some embodiments, the housing is disposed within a terrestrial structure.

In some embodiments, the radius of the curvature of the sheet is such that the sheet has a depth of not less than 5% nor greater than 20% of the width of the sheet.

In some embodiments, the lenticular shape of the sheet is flattened when it is mounted under compression on the spool in the stowed configuration.

In some embodiments, the housing includes an aperture through which the rectangular sheet is deployed.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the claims.

### BRIEF DESCRIPTION OF THE DRAWINGS

To complete the description and in order to provide for a better understanding of the disclosure, a set of drawings is provided. The drawings form an integral part of the description and illustrate embodiments of the disclosure, which should not be interpreted as restricting the scope of the disclosure, but just as examples of how the disclosure can be carried out. The drawings comprise the following figures:
FIG. 1 is an illustration of an exemplary CubeSat having a spool for storing one or more solar cell arrays;
FIG. 2 is an illustration of the exemplary CubeSat of FIG. 1 attached to three additional CubeSats and having the solar cell arrays in a deployed state;
FIG. 3A is an illustration of the exemplary CubeSat of FIG. 1 attached to two additional CubeSats and having the solar cell array in a deployed state;
FIG. 3B is an illustration of the exemplary CubeSat of FIG. 1 having the solar cell arrays in a deployed state;
FIG. 4A is another view of the exemplary CubeSat of FIG. 1 having the solar cell arrays in a deployed state;
FIG. 4B is a view through the B-B plane of FIG. 4A showing the solar cell arrays in a deployed state; and
FIG. 4C is a view through the B-B plane of FIG. 4A showing the solar cell arrays in a stowed state.

### DESCRIPTION OF ILLUSTRATIVE EMBODIMENTS

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

In the most general terms, the present disclosure relates to deployable booms associated with vehicles or permanent structures, the booms being structured components, or assemblies including, in some embodiments, transducers for collecting or emitting electromagnetic energy. One embodiment of the present disclosure depicts a space vehicle such as a satellite, in which the boom enables a compact stowed configuration of the deployable assembly during launch into space, and automatic deployment when the satellite reaches the desired orbit.

In some embodiments, the assembly may be an array of solar cells, while in other embodiments, the assembly may be other types of operational devices such as sensors, antennas, optical elements, or thermal or other types of radiative elements.

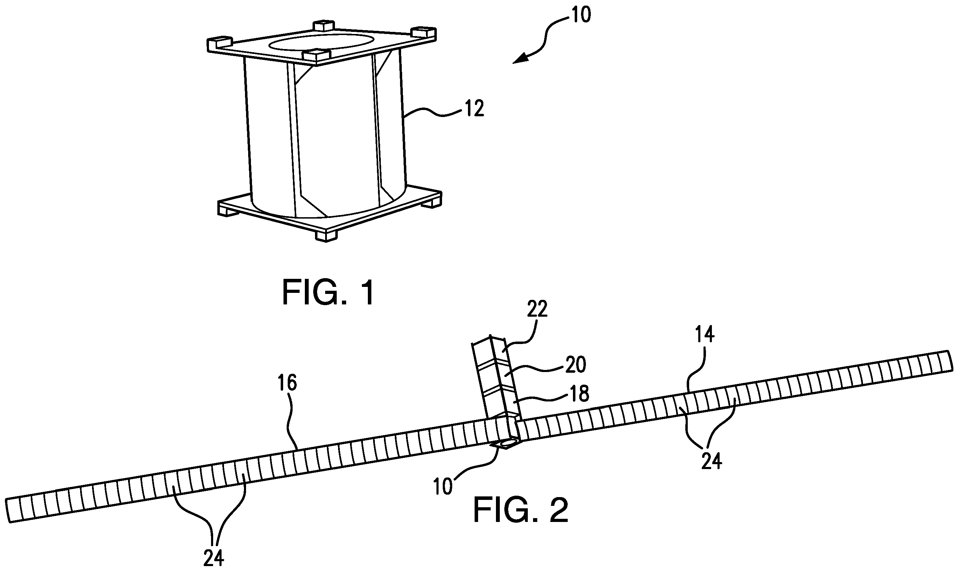

As shown with respect to FIGS. 1 and 2 a small spacecraft such as a CubeSat 10 has a mandrel (e.g., a spool) 12 for storing one or more deployable arrays 14, 16 of photovoltaic devices 24. As mentioned above, a CubeSat is a type of miniaturized satellite. A typical CubeSat is a 10 cm x 10 cm x 10 cm cube, thus having a volume of one liter; other dimensions are possible as well. In some cases, CubeSats can be attached to one another in strings or blocks to provide functionalities and capabilities that would not otherwise be practically available in a single CubeSat. For example, one CubeSat can be used as a power source to supply power necessary for other attached CubeSats to perform their functions.

The arrays 14, 16 can be used, for example, as a power source to supply power to one or more additional CubeSats 18, 20, 22 attached to the CubeSet 10. For example, in some implementations, each array(s) 14, 16 is suitable for providing a small amount of power (e.g., less than 50 watts). In the illustrated example, the photovoltaic devices 24 are solar cells. In some instances, each array 14, 16 of photovoltaic devices 24 includes a first module having a first side dimension, and a second module having a second side dimension different from the first side dimension. Each module can include, for example, a plurality of discrete solar cells connected in a serial or parallel configuration. In some implementations, each array 14, 16 of photovoltaic devices 24 includes an array of coverglass-interconnected-solar cells (CICs) mounted on the polyimide carrier by a pressure sensitive adhesive.

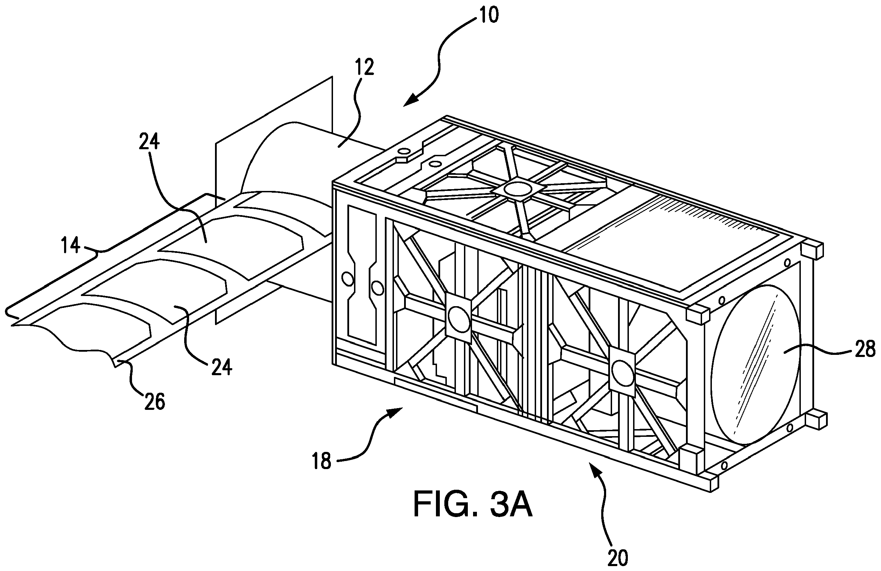

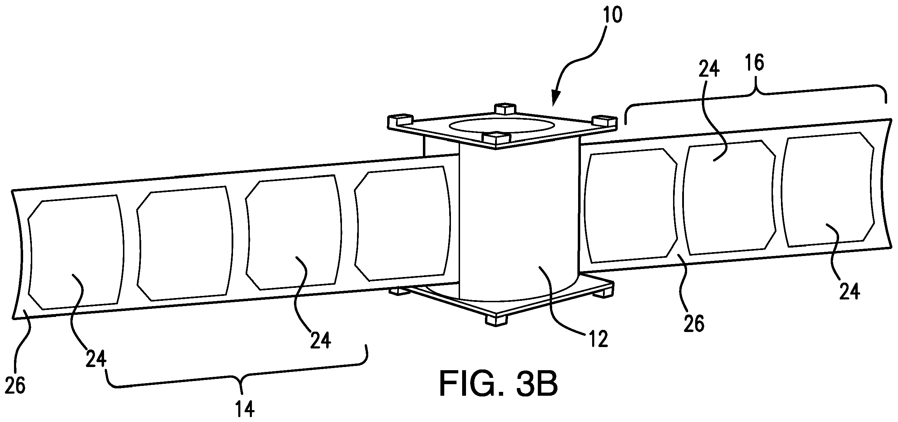

As shown in FIGS. 3A and 3B, the photovoltaic devices 24 of each array 14, 16 can be supported, for example, by a respective flexible, elongated, rectangular sheet 26 composed of a composite laminate having a predetermined pattern of graphite fiber plies which impart a predefined tension in the planar surface of the sheet so that it curls into a curvilinear sheet having a uniform radius of curvature along its major axis. For example, in some implementations, the pattern of graphite fiber plies consists of at least intermediate modulus 7 (IM7) plies oriented at least 30° apart from each other. In some instances, the graphite fiber plies give the sheet 26 a strength of up to 0.28 g, a capability of handling stress when deployed at a vibration frequency of up to 0.9 Hz, and a stability of up to 1 milli - g under deployed flight loading. In some instances, each sheet 26 has a width of less than 100 mm. The foregoing dimension may differ for other implementations.

In combination, the solar cells 24 and the flexible sheet 26 on which they are mounted form a solar cell assembly. In some cases, the solar cells 24 are mounted indirectly on the sheet 26. For example, the solar cells 24 can be mounted on a polyimide carrier, which is bonded to the composite laminate sheet 26. The flexible sheet 26 can have a thickness, for example, of between 0.1 mm and 0.3 mm. Further, the solar cell assemblies can have a side length such that when mounted on the polyimide carrier and wrapped around the spool 12 in the stowed configuration, the solar cell assemblies bend no more than a small amount out of plane. The foregoing dimensions may differ for other implementations.

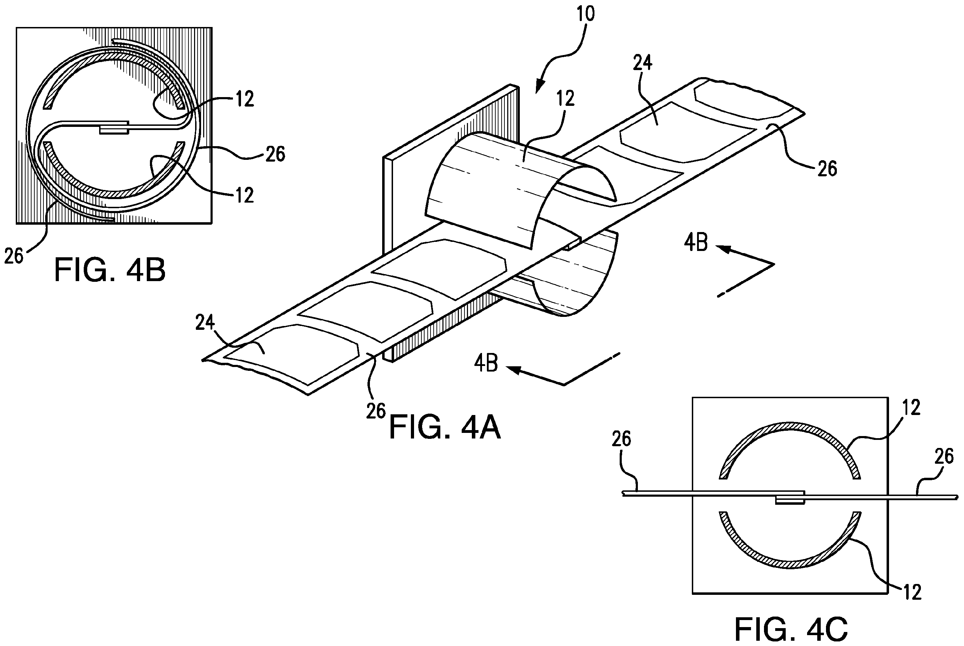

In the illustrated example, the mandrel (e.g., spool) 12 for supporting the sheets 26 is disposed within a one unit CubeSat housing 30. The sheets 26 can be arranged in a deployed configuration (as shown, e.g., in FIGS. 2, 3A, 3B, 4A and 4B), or in a stowed configuration (as shown, e.g., in FIG. 4B). In the stowed configuration, the sheets 26 are coiled or wound about the spool 12 under compressive force. In particular, in the stowed configuration, each sheet 26 can be circumferentially wound to form a spool configuration in a stationary position (see FIG. 4B). Upon deployment to the deployed configuration, as each sheet 26 unwinds from the spool configuration, the sheet 26 forms into a planar cylindrical portion sheet having a uniform cross-sectional curvature. In some implementations, the substrate is adapted to store strain energy when elastically deformed, and the assembly can transition from the stowed configuration to the deployed configuration using the stored strain energy. Thus, each sheet 26 can be released from the stowed configuration (FIG. 4B) by releasing the spool 12 to allow it to rotate during a deployment operation so that the sheet automatically deploys from the spool (FIG. 4A). As the sheet 26 unwinds from the spool 12, the sheet 26 forms a substantially planar sheet having a uniform curvature. The CubeSet 10 can include one or more deployment apertures for enabling the automatic unwinding of the sheets 26 from the spool 12 during the deployment operation so that a first sheet 26 is deployed in a first direction from the CubeSet and a second sheet 26 is deployed in the same plane as the first sheet but in an opposite direction from the CubeSet.

As mentioned above, in some instances, the CubeSat 10 is attached to one or more additional CubeSats. As shown, for example in FIG. 3A a string of three CubeSats includes the CubeSat 10 of FIG. 1 having a solar cell array 14 in a deployed state and being attached to a second CubeSat 18 and a third CubeSat 20. The third CubeSat 20 can include a lens 28 on its exposed surface.

It is to be noted that the terms "front," "back," "top," "bottom," "over," "on," "under," and the like in the description and in the claims, if any, are used for descriptive purposes and not necessarily for describing permanent relative positions. It is understood that the terms so used are interchangeable under appropriate circumstances such that the embodiments of the disclosure described herein are, for example, capable of operation in other orientations than those illustrated or otherwise described herein.

Furthermore, those skilled in the art will recognize that boundaries between the above described units/operations are merely illustrative. The multiple units/operations may be combined into a single unit/operation, a single unit/operation may be distributed in additional units/operations, and units/operations may be operated at least partially overlapping in time. Moreover, alternative embodiments may include multiple instances of a particular unit/operation, and the order of operations may be altered in various other embodiments.

In the claims, the word 'comprising' or 'having' does not exclude the presence of other elements or steps than those listed in a claims. The terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to disclosures containing only one such element, even when the claim includes the introductory phrases "one or more" or "at least one" and indefinite articles such as "a" or "an". The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The fact that certain measures are recited in mutually different claims does not indicate that a combination of these measures cannot be used to advantage.

## Claims

1. A method of deploying an extensible boom from a housing comprising:
providing a support including an array (14) of transducer devices;
mounting the support on a first flexible, elongated, rectangular sheet (26) in a housing;
supporting the sheet on a spool (12) in the housing under compression in a stowed configuration; wherein
the sheet (26) is composed of a composite laminate having a predetermined pattern of graphite fiber plies which impart a predefined tension in the planar surface of the sheet so that it curls into a curvilinear sheet, **characterised in that** the curvilinear sheet has a uniform radius of curvature along its major axis;
and **in that**
the method further comprises the step of releasing the spool (12) so that the sheet (26) unwinds automatically and is deployed from the housing in a linear direction.

2. A method of deploying an extensible boom from a housing as defined in claim 1, wherein the array of transducer devices comprises (i) an array of photovoltaic devices (24); (ii) an array of semiconductor sensors; (iii) an antenna array; and/or (iv) thermal transfer elements; and
the transducers are mounted on a polyimide carrier and the polyimide carrier is bonded to the composite laminate.

3. A method of deploying an extensible boom from a housing as defined in any of the preceding claims, wherein the flexible sheet (26) has a thickness of between 0.1 mm and 0.5 mm, a width of less than 10 cm, and a length of between 10 and 200 cm after full deployment.

4. A method of deploying an extensible boom from a housing as defined in any of the preceding claims, wherein the array (14, 16) of transducer devices include a first transducer module having a first side dimension, and a second transducer module having a second side dimension different from the first side dimension.

5. A method of deploying an extensible boom from a housing as defined in claim 4, wherein each transducer module includes a plurality of discrete photovoltaic solar cells connected in an electrical serial or parallel configuration mounted on the polyimide carrier by a pressure sensitive adhesive.

6. A method of deploying an extensible boom from a housing as defined in any of the preceding claims, wherein the pattern of graphite fiber plies is pre-impregnated with resin and consist of at least intermediate modulus graphite fiber reinforced plies to impart substantially uniform strength, stiffness, and flexibility, and the graphite fiber plies gives the sheet (26) a strength of up to 2.0 g and a stiffness resulting in a natural frequency greater than 0.01 Hz.

7. A method of deploying an extensible boom from a housing as defined in any of the preceding claims, wherein the sheet (26) is circumferentially wound to form a spool configuration in a stowed configuration, and forms into a planar cylindrical portion sheet having a uniform cross-sectional curvature as it unwinds from the spool configuration upon deployment to the deployed configuration.

8. A method of deploying an extensible boom from a housing as defined in any of the preceding claims, wherein the sheet (26) is stored within a one unit CubeSat housing for a space vehicle in its stowed configuration.

9. A method of deploying an extensible boom from a housing as defined in any of the preceding claims, further comprising:
providing a second flexible, elongated, substantially rectangular sheet (26) for supporting a plurality of transducer assemblies (16);
supporting the second rectangular sheet (26) in a spooled configuration under compression on a mandrel (12) in a stationary position in a stowed configuration; and
releasing the second sheet (26) from the spooled configuration by releasing the mandrel (12) to allow it to rotate during a deployment operation so that the sheet (26) automatically deploys from the mandrel (12) and curls into a curvilinear sheet having a uniform radius of curvature along its major axis and extending substantially linearly away from the housing.

10. A method of deploying an extensible boom from a housing as defined in claim 9, wherein the first and second sheets (26) are substantially simultaneously deployed so that the first sheet (26) is deployed in a first direction from the housing and the second sheet (26) is deployed in the same plane as the first sheet but in an opposite direction from the housing, and the housing is disposed in a spacecraft composed of CubeSat modules, wherein the first and second rectangular sheets (26) are stowed within a one unit CubeSat housing.

11. A method of deploying an extensible boom from a housing as defined in any of the preceding claims, wherein the housing is disposed in a vehicle.

12. A method of deploying an extensible boom from a housing as defined in any of claims 1-10, wherein the housing is disposed within a terrestrial structure.

13. A method of deploying an extensible boom from a housing as defined in any of the preceding claims, wherein the radius of the curvature of the sheet (26) is such that the sheet has a depth of not less than 5% nor greater than 20% of the width of the sheet.

14. A method of deploying an extensible boom from a housing as defined in any of the preceding claims, wherein a lenticular shape of the sheet (26) is flattened when it is mounted under compression on the spool in the stowed configuration.

15. A method of deploying an extensible boom from a housing as defined in any of the preceding claims, wherein the housing includes an aperture through which the rectangular sheet (26) is deployed.

## Patentansprüche

1. Verfahren zum Ausfahren eines ausfahrbaren Auslegers aus einem Gehäuse, umfassend:
Vorsehen einer Abstützung, die ein Feld (14) von Wandlervorrichtungen aufweist;
Montieren der Abstützung auf einer ersten flexiblen, länglichen, rechteckigen Bahn (26) in einem Gehäuse;
Abstützen der Bahn auf einer Spule (12) in dem Gehäuse unter Druck in einer verstauten Konfiguration; wobei
die Bahn (26) aus einem Schichtverbundstoff besteht, der ein vorbestimmtes Muster aus Graphitfaserschichten hat, welche eine vorbestimmte Spannung in der planen Oberfläche der Bahn ausüben, sodass sich diese in eine gekrümmte Bahn krümmt, **dadurch gekennzeichnet, dass** die gekrümmte Bahn entlang ihrer Hauptachse einen gleichmäßigen Krümmungsradius aufweist;
und dass
das Verfahren ferner den Schritt des Loslassens der Spule (12) umfasst, sodass die Bahn (26) sich automatisch entrollt und aus dem Gehäuse in einer geradlinigen Richtung ausgefahren wird.

2. Verfahren zum Ausfahren eines ausfahrbaren Auslegers aus einem Gehäuse gemäß Anspruch 1, wobei das Feld von Wandlervorrichtungen umfasst: i) ein Feld von photovoltaischen Vorrichtungen (24); ii) ein Feld von Halbleitersensoren; iii) ein Antennenfeld; und/oder iv) Wärmeübertragungselemente; und
die Wandler auf einem Polyimid-Träger montiert sind und der Polyimid-Träger auf den Schichtverbundstoff geklebt ist.

3. Verfahren zum Ausfahren eines ausfahrbaren Auslegers aus einem Gehäuse gemäß einem der vorhergehenden Ansprüche, wobei die flexible Bahn (26) eine Dicke von zwischen 0,1 mm und 0,5 mm, eine Breite von weniger als 10 cm und eine Länge von zwischen 10 und 200 cm nach dem vollständigen Ausfahren hat.

4. Verfahren zum Ausfahren eines ausfahrbaren Auslegers aus einem Gehäuse gemäß einem der vorhergehenden Ansprüche, wobei die Anordnung (14, 16) von Wandlervorrichtungen ein erstes Wandlermodul, das eine erste Seitenabmessung hat, und ein zweites Wandlermodul aufweist, das eine zweite Seitenabmessung hat, die sich von der ersten Seitenabmessung unterscheidet.

5. Verfahren zum Ausfahren eines ausfahrbaren Auslegers aus einem Gehäuse gemäß Anspruch 4, wobei jedes Wandlermodul eine Vielzahl diskreter photovoltaischer Solarzellen aufweist, die in einer in Reihe oder parallel elektrisch miteinander verschalteten Konfiguration sind, die über einen Haftkleber auf dem Polyimid-Träger montiert ist.

6. Verfahren zum Ausfahren eines ausfahrbaren Auslegers aus einem Gehäuse gemäß einem der vorhergehenden Ansprüche, wobei das Muster von Graphitfaserschichten mit Kunstharz vorimprägniert ist und aus Schichten besteht, die mit Graphitfasern eines mindestens mittleren E-Moduls verstärkt sind, um ihnen eine im Wesentlichen gleichmäßige Festigkeit, Steifigkeit und Flexibilität zu verleihen, und die Graphitfaserschichten der Bahn (26) eine Festigkeit von bis zu 2,0 g und eine Steifigkeit geben, die in einer Eigenfrequenz von mehr als 0,01 Hz resultieren.

7. Verfahren zum Ausfahren eines ausfahrbaren Auslegers aus einem Gehäuse gemäß einem der vorhergehenden Ansprüche, wobei die Bahn (26) im Umfangsrichtung aufgewickelt ist, um in der verstauten Konfiguration eine Spulenkonfiguration auszubilden, und die Form einer planen Teil-Zylinder-Bahn annimmt, die im Querschnitt eine gleichmäßige Krümmung hat, während sie sich beim Ausfahren in die ausgefahrene Konfiguration aus der Spulenkonfiguration abwickelt.

8. Verfahren zum Ausfahren eines ausfahrbaren Auslegers aus einem Gehäuse gemäß einem der vorhergehenden Ansprüche, wobei die Bahn (26) in deren verstauter Konfiguration in einem Einzel-Einheits-CubeSat-Gehäuse für ein Raumfahrzeug aufbewahrt wird.

9. Verfahren zum Ausfahren eines ausfahrbaren Auslegers aus einem Gehäuse gemäß einem der vorhergehenden Ansprüche, ferner umfassend:
Vorsehen einer zweiten flexiblen, länglichen, im Wesentlichen rechteckigen Bahn (26) zum Abstützen einer Vielzahl von Wandleranordnungen (16);
Abstützen der zweiten rechteckigen Bahn (26) in einer aufgewickelten Konfiguration unter Druck auf einem Dorn (12) in einer stationären Position in einer verstauten Konfiguration; und
Entlassen der zweiten Bahn (26) aus der aufgewickelten Konfiguration durch Loslassen des Dorns (12), um es ihm zu ermöglichen, sich während eines Ausfahrvorgangs zu drehen, sodass die Bahn (26) automatisch von dem Dorn (12) ausfährt und sich in eine gekrümmte Bahn krümmt, die entlang ihrer Hauptachse einen gleichmäßigen Krümmungsradius hat und sich im Wesentlichen geradlinig von dem Gehäuse aus erstreckt.

10. Verfahren zum Ausfahren eines ausfahrbaren Auslegers aus einem Gehäuse gemäß Anspruch 9, wobei die erste und die zweite Bahn (26) im Wesentlichen gleichzeitig ausgefahren werden, sodass die erste Bahn (26) ausgehend von dem Gehäuse in einer ersten Richtung ausgefahren wird, und die zweite Bahn (26) in derselben Ebene wie die erste Bahn, jedoch ausgehend von dem Gehäuse in einer entgegengesetzten Richtung ausgefahren wird, und das Gehäuse in einem Raumfahrzeug angeordnet ist, das aus CubeSat-Modulen besteht, wobei die erste und die zweite rechteckige Bahn (26) in einem Einzel-Einheits-CubeSat-Gehäuse verstaut werden.

11. Verfahren zum Ausfahren eines ausfahrbaren Auslegers aus einem Gehäuse gemäß einem der vorhergehenden Ansprüche, wobei das Gehäuse in einem Fahrzeug angeordnet ist.

12. Verfahren zum Ausfahren eines ausfahrbaren Auslegers aus einem Gehäuse gemäß einem der Ansprüche 1 bis 10, wobei das Gehäuse in einer terrestrischen Struktur angeordnet ist.

13. Verfahren zum Ausfahren eines ausfahrbaren Auslegers aus einem Gehäuse gemäß einem der vorhergehenden Ansprüche, wobei der Radius der Krümmung der Bahn (26) so ist, dass die Bahn eine Tiefe von nicht weniger als 5% und nicht mehr als 20% der Breite der Bahn hat.

14. Verfahren zum Ausfahren eines ausfahrbaren Auslegers aus einem Gehäuse gemäß einem der vorhergehenden Ansprüche, wobei eine linsenartige Form der Bahn (26) abgeflacht wird, wenn sie in der verstauten Konfiguration unter Druck auf der Spule montiert ist.

15. Verfahren zum Ausfahren eines ausfahrbaren Auslegers aus einem Gehäuse gemäß einem der vorhergehenden Ansprüche, wobei das Gehäuse eine Öffnung aufweist, durch die die rechteckige Bahn (26) ausgefahren wird.

## Revendications

1. Procédé pour déployer une flèche extensible d'un logement comprenant:
fournir un support comprenant un réseau (14) de dispositifs transducteurs ;
monter le support sur une première feuille rectangulaire allongée flexible (26) dans un logement ;
supporter la feuille sur une bobine (12) dans le logement sous compression dans une configuration repliée ; dans lequel :
la feuille (26) est composée d'un stratifié composite ayant un motif prédéterminé de plis de fibres en graphite qui communiquent une tension prédéfinie dans la surface planaire de la feuille de sorte qu'elle s'enroule en une feuille curviligne, **caractérisé en ce que** la feuille curviligne a un rayon de courbure uniforme le long de son axe majeur ;
et **en ce que** :
le procédé comprend en outre l'étape de libération de la bobine (12) de sorte que la feuille (26) se déroule automatiquement et est déployée du logement dans une direction linéaire.

2. Procédé pour déployer une flèche extensible d'un logement selon la revendication 1, dans lequel le réseau de dispositifs transducteurs comprend (i) un réseau de dispositifs photovoltaïques (24) ; (ii) un réseau de capteurs semiconducteurs ; (iii) un réseau d'antennes ; et/ou (iv) des éléments de transfert thermiques ; et
les transducteurs sont montés sur un support en polyimide et le support en polyimide est relié au stratifié composite.

3. Procédé pour déployer une flèche extensible d'un logement selon l'une quelconque des revendications précédentes, dans lequel la feuille flexible (26) a une épaisseur comprise entre 0,1 mm et 0,5 mm, une largeur inférieure à 10 cm et une longueur comprise entre 10 et 200 cm après le déploiement complet.

4. Procédé pour déployer une flèche extensible d'un logement selon l'une quelconque des revendications précédentes, dans lequel le réseau (14, 16) de dispositifs transducteurs comprend un premier module transducteur ayant une première dimension latérale, et un second module transducteur ayant une seconde dimension latérale différente de la première dimension latérale.

5. Procédé pour déployer une flèche extensible d'un logement selon la revendication 4, dans lequel chaque module de transducteur comprend une pluralité de cellules solaires photovoltaïques discrètes raccordées dans une configuration électrique en série ou parallèle, montée sur le support en polyimide par un adhésif sensiblement à la pression.

6. Procédé pour déployer une flèche extensible d'un logement selon l'une quelconque des revendications précédentes, dans lequel le motif des plis de fibres en graphite est préimprégné avec de la résine et consiste en au moins de plis renforcés en fibres en graphite à module intermédiaire pour communiquer une résistance, rigidité et flexibilité sensiblement uniformes, et les plis de fibres en graphite donne à la feuille (26) une force jusqu'à 2,0 g et une rigidité se traduisant par une fréquence naturelle supérieure à 0,01 Hz.

7. Procédé pour déployer une flèche extensible d'un logement selon l'une quelconque des revendications précédentes, dans lequel la feuille (26) est enroulée de manière circonférentielle pour former une configuration de bobine dans une configuration repliée, et se forme en une feuille de partie cylindrique planaire ayant une courbure transversale uniforme lorsqu'elle se déroule de la configuration de bobine suite au déploiement dans la configuration déployée.

8. Procédé pour déployer une flèche extensible d'un logement selon l'une quelconque des revendications précédentes, dans lequel la feuille (26) est stockée dans un logement unitaire CubeSat pour un véhicule spatial dans une configuration repliée.

9. Procédé pour déployer une flèche extensible d'un logement selon l'une quelconque des revendications précédentes, comprenant en outre:
fournir une seconde feuille sensiblement rectangulaire, allongée flexible (26) pour supporter une pluralité d'ensembles de transducteurs (16) ;
supporter une seconde feuille rectangulaire (26) dans une configuration enroulée sous compression sur un mandrin (12) dans une position fixe dans une configuration repliée ; et
libérer la seconde feuille (26) de la configuration enroulée en libérant le mandrin (12) pour lui permettre de tourner pendant une opération de déploiement de sorte que la feuille (26) se déploie automatiquement du mandrin (12) et s'enroule en une feuille curviligne ayant un rayon de courbure uniforme le long de son axe majeur et s'étendant de manière sensiblement linéaire à distance du logement.

10. Procédé pour déployer une flèche extensible d'un logement selon la revendication 9, dans lequel les première et seconde feuilles (26) sont déployées de manière sensiblement simultanée de sorte que la première feuille (26) est déployée dans une première direction depuis le logement et la seconde feuille (26) est déployée dans le même plan que la première feuille mais dans une direction opposée au logement, et le logement est disposé dans un engin spatial composé de modules CubeSat, dans lequel les première et seconde feuilles rectangulaires (26) sont repliées dans un logement unitaire CubeSat.

11. Procédé pour déployer une flèche extensible d'un logement selon l'une quelconque des revendications précédentes, dans lequel le logement est disposé dans un véhicule.

12. Procédé pour déployer une flèche extensible d'un logement selon l'une quelconque des revendications 1 à 10, dans lequel le logement est disposé dans une structure terrestre.

13. Procédé pour déployer une flèche extensible d'un logement selon l'une quelconque des revendications précédentes, dans lequel le rayon de courbure de la feuille (26) est tel que la feuille a une profondeur qui n'est pas inférieure à 5% ni supérieure à 20% de la largeur de la feuille.

14. Procédé pour déployer une flèche extensible d'un logement selon l'une quelconque des revendications précédentes, dans lequel une forme lenticulaire de la feuille (26) est aplatie lorsqu'elle est montée sous compression sur la bobine dans la configuration repliée.

15. Procédé pour déployer une flèche extensible d'un logement selon l'une quelconque des revendications précédentes, dans lequel le logement comprend une ouverture au travers de laquelle la feuille rectangulaire (26) est déployée.
